# EUROPEAN PATENT APPLICATION

(11) **EP 3 696 561 A1**
(43) Date of publication of application: **19.08.2020**
(21) Application number: 19157075.3
(22) Date of filing: 14.02.2019
(51) Int. Cl.: G01R 33/36, G01R 33/565

(54) **SWITCHABLE IMPEDANCE MATCHING FOR NOISE-BASED MOTION DETECTION IN MAGNETIC RESONANCE IMAGING**

(71) Applicant: Koninklijke Philips N.V., 5656 AG Eindhoven (NL)
(72) Inventor: WUELBERN, Jan Hendrik, 5656 AE Eindhoven (NL); MEINEKE, Jan Jakob, 5656 AE Eindhoven (NL); LEUSSLER, Christoph, 5656 AE Eindhoven (NL)
(74) Representative: de Haan, Poul Erik

(57) **Abstract**

The invention relates to a system for detecting subject motion in magentic resonance imaging. It is proposed herein to increase the sensitivity of noise data to subject motion by changing the pre-amplifiers (3) operating point appropriately. A switchable impedance matching circuit (4) is placed in the RF receive chain (1), which allows adjustment of the load impedance presented to the pre-amplifier (3) by the RF coil (2, 9) to different operating points. In order to adjust the load impedance, the system proposed herein comprises a first impedance matching circuit (5), wherein the first impedance matching circuit (5) has an operating point that is optimized for an high Signal-to-Noise-Ratio. The switchable impedance matching circuit (4) further comprises a second impedance matching circuit (6), wherein the second impedance matching circuit (6) has an operating point that is optimized for high derivative noise figure with respect to the input impedance of the pre-amplifier. In contrast, the proposed switchable impedance matching circuit (4) is capable of adjusting the load impedance presented to the pre-amplifier (3) by the RF receive coil (2, 9) without the need for setting the operating point of a single impedance matching circuit from a minimal noise figure input impedance to a region where the absolute value derivative of the noise figure in terms of input impedance is maximal. The present invention further provides a magnetic resonance imaging system comprising a system for detecting subject motion in magnetic resonance imaging. The present invention further provides a method for detecting subject motion in magnetic resonance imaging, a computer program product for motion detection in magnetic resonance imaging and a computer readable medium containing program instructions for execution on a computer system.

## Description

### FIELD OF THE INVENTION

The invention relates to the field of magnetic resonance (MR) imaging. In particular, the present invention relates to the field of detecting subject motion in magnetic resonance imaging.

### BACKGROUND OF THE INVENTION

Magnetic resonance tomography is a valuable imaging modality of the human body as it offers excellent soft tissue contrast without the use of ionizing radiation. A major disadvantage of MRI is its long acquisition time, which, depending on the imaging volume and resolution may range from tens of seconds up to several minutes. As such, the acquisition is prone to motion artefacts due to movements of the subject during the scan. Motion is commonly detected by means of external (respiration belt, PPU, ECG, markers, camera, etc.) or internal navigators (pencil beam, orbital, etc.). The former introduces additional preparation time of the patient prior to scanning, while the latter may require additional examination planning and/or increase sequence execution time. Hence, deriving the motion information from the MR data itself would be ideal. Thermal noise is an unavoidable and typically undesired component of the measured MR data; however, it may be used to derive subject motion. It has been shown, that the variance of thermal noise measured with the RF receive coil can be used to measure respiratory motion. Due to the very nature of thermal noise, the encoding of motion information is relatively weak in the samples noise data. The variations in the thermal noise result from changes in the coil's resistance due to motion of the examined subject. The output impedance of the RF coil is transformed to the pre-amplifier's minimal noise figure input impedance using a matching network. This matching shall ensure maximum SNR for the acquired imaging data. However, this operating point is typically the least sensitive to changes to the input load and hence not optimal for the detection of noise variations.

The reference EP3304114A1 suggests correlating received noise from multiple coil channels to derive a motion marker. The reference discloses for an instrument comprising: a radio-frequency antenna comprising multiple antenna elements; a radio-frequency system comprising independent receive channels for receiving a radio-frequency signal from each of the multiple antenna elements; a memory containing machine executable instructions; and a processor for controlling the instrument. Execution of the machine executable instructions causes the processor to: control the radio-frequency system to receive the radio frequency signal from each of the multiple antenna elements; extract a noise signal from the radio frequency signal from each of the multiple antenna elements; calculate a normed signal for each noise signal by applying a mathematical norm to each noise signal; calculate a covariance of the normed signal between each of the multiple antenna elements; calculate a motion signal by summing each covariance of the normed signal; and detect motion of a subject by detecting a motion event in the motion signal.

Accurate and efficient motion estimation is critical in MRI studies to achieve better anatomical resolution and faithful physiological analysis. However, most of the existing quantitative motion estimation methods require great amount of extra time cost for acquisition, post-processing, extensive registration or additional hardware/equipment. A drawback is also that the measured thermal noise signal of an amplifier is too weak to determine motion accurately.

### SUMMARY OF THE INVENTION

It is an object of the invention to provide a system for detecting subject motion in magnetic resonance imaging that accurately estimates subject motion using the noise correlation information intrinsically existing in all magnetic resonance imaging signals.

According to the invention, this object is addressed by the subject matter of the independent claims. Preferred embodiments of the invention are described in the sub claims.

Therefore, according to the invention, a system for detecting subject motion in magnetic resonance imaging the system is foreseen comprising: at least one radio frequency (RF) receive chain with at least one RF coil, wherein the RF coil is configured for at least receiving RF signals, the RF coil being connected, via a switchable impedance matching circuit to at least one pre-amplifier, wherein the switchable impedance matching circuit comprises, a first impedance matching circuit, wherein the first impedance matching circuit has an operating point that is optimized for an high Signal-to-Noise-Ratio, the switchable impedance matching circuit further comprises at least a second impedance matching circuit, wherein the second impedance matching circuit has an operating point that is optimized for high derivative noise figure with respect to an input impedance of the pre-amplifier.

The invention uses a switchable impedance matching circuit in the RF receive chain, which allows adjustment of the load impedance presented to the pre-amplifier. The sensitivity of noise data to subject motion is increased by changing the pre-amplifiers operating point appropriately. For the acquisition of the noise signal for motion detection the switchable impedance matching circuit comprises a second impedance matching circuit, wherein the second impedance matching circuit has an operating point that is optimized for high derivative noise figure with respect to the input impedance of the pre-amplifier. The switchable impedance matching circuit is capable of adjusting the load impedance presented to the pre-amplifier by the RF coil without the need for setting the operating point of a single impedance matching circuit from a minimal noise figure input impedance to a region where the absolute value derivative of the noise figure in terms of input impedance is maximal.

In a preferred embodiment of the invention the system the RF coil is a RF receiver coil or a transmit/receive (Tx/Rx) coil. Alternatively, a RF coil only for the RF transmission mode and a RF coil only for the RF receiving mode are separately used to separately perform the RF transmission mode and the RF receiving mode. A coil that performs both the RF transmission mode and the RF receiving mode is referred to as a transmit/receive (Tx/Rx) coil. A Tx only coil is referred to as a transmission coil, and a Rx only coil is referred to as a receiving coil. The combination of a transmit and receive RF coil in a single device can be useful for certain MRI applications.

In another preferred embodiment of the invention the system comprises a first switch to switch the receiver coil between the first impedance matching circuit and the second impedance matching circuit.

In a preferred embodiment of the invention the switch is a transmit/receive (Tx/Rx) switch. Due to Rx and Tx sharing the same coil, the correct signal path must be switched by a switching unit. A Tx/Rx switch has the advantage of a high power handling cap ability, low insertion loss, very high isolation between Rx and Tx ports and high switching speed.

Acording to another preferred embodiment of the invention the system comprises a second switch to switch the first impedance matching circuit or the second impedance matching to the at least one pre-amplifier.

According to a preferred embodiment of the invention the RF coil is a multi frequency RF coil.

In a preferred embodiment the multi frequency RF coil is connected to the pre-amplifier via the switchable impedance matching circuit wherein the switching between the first impedance matching circuit and the second impedance matching circuit is realized by switching the frequency of the multi frequency RF coil.

According to another preferred embodiment a pre-amplifier is connected to the first impedance matching circuit and a pre-amplifier is connected to the second impedance matching circuit. The advantage of a pre-amplifier for every impedance matching circuit is that the signal used for MR imaging and the noise signal used for the motion prediction can be measured simultaneously.

In another preferred embodiment the switch is a PIN device or a MEM device. MR compatible RF switching technology requiring minimal interfacing and allowing switching of RF signals with low power consumption and insertion loss are of benefit in the construction of practical, high density receive coil arrays for clinical MRI scanners. Therefore, MEM-devices or PIN devices placed on a location with relative low current or high voltage introduce minimum noise itself. At, least the noise resulting from an additional switch is an order magnitude lower than the variance of the thermal noise.

Moreover, a method for detecting subject motion in magnetic resonance imaging is disclosed in accordance with the invention, the method comprising the following steps:
- providing at least one RF receive chain with at least one RF coil, wherein the RF coil is configured for at least receiving RF signals,
- providing a switchable matching circuit, wherein the switchable impedance matching circuit comprises, a first impedance matching circuit, wherein the first impedance matching circuit has an operating point that is optimized for an high Signal-to-Noise-Ratio, the switchable impedance matching circuit further comprises at least a second impedance matching circuit wherein the second impedance matching circuit has an operating point that is optimized for high derivative noise figure with respect to an input impedance of the pre-amplifier,
- switching the RF coil to the second impedance matching circuit,
- aquiring noise with the RF coil,
- estimating subject motion by the measured noise.

According to a preferred embodiment of the invention the method further comprises the steps of:
- predicting a subject motion state from a prospective model,
- correcting magnetic resonance imaging acquisition parameters, based on the predicted subject motion state,
- setting the magnetic resonance imaging acquisition parameters,
- aquiring magnetic resonance image data.

In another preferred embodiment of the invention the step of switching the RF coil to the second impedance matching circuit, includes the step of setting the second impedance matching circuit to a region where the absolute value of the derivative of the noise figure in terms of the input impedance is maximal.

The invention also relates to magnetic resonance imaging system comprising a system for detecting subject motion described above. Because the acquisition is prone to motion artefacts due to movements of the subject during the scan the system for detecting subject motion improves the performance of the magnetic resonance imaging system as a whole.

The invention also relates to a computer program product for motion detection in magnetic resonance imaging when executed by a computer, said computer program product carrying out the method method described above.

The invention also relates to a computer readable medium containing program instructions for execution on a computer system, which when executed by a computer, cause the computer to perform method steps for detecting subject motion.

Some aspects of this invention, such as the detecting of subject motion in magnetic resonance imaging may also be implemented in the form of software, notably in the form of software packages that upgrade already installed software to enable installed magnetic resonance imaging system to also operate according to the present invention.

The invention relates to a system for detecting subject motion in magentic resonance imaging. It is proposed herein to increase the sensitivity of noise data to subject motion by changing the pre-amplifiers operating point appropriately. A switchable impedance matching circuit is placed in the RF receive chain, which allows adjustment of the load impedance presented to the pre-amplifier by the RF coil to different operating points. In order to adjust the load impedance, the system proposed herein comprises a first impedance matching circuit, wherein the first impedance matching circuit has an operating point that is optimized for an high Signal-to-Noise-Ratio. The switchable impedance matching circuit further comprises a second impedance matching circuit, wherein the second impedance matching circuit has an operating point that is optimized for high derivative noise figure with respect to the input impedance of the pre-amplifier. In contrast, the proposed switchable impedance matching circuit is capable of adjusting the load impedance presented to the pre-amplifier by the RF coil without the need for setting the operating point of a single impedance matching circuit from a minimal noise figure input impedance to a region where the absolute value derivative of the noise figure in terms of input impedance is maximal. The present invention further provides a magnetic resonance imaging system comprising a system for detecting subject motion in magnetic resonance imaging. The present invention further provides a method for detecting subject motion in magnetic resonance imaging, a computer program product for motion detection in magnetic resonance imaging and a computer readable medium containing program instructions for execution on a computer system.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a RF receive chain with a system for motion detection in magnetic resonance imaging in accordance with an embodiment of the invention,
Fig. 2 schematically depicts a RF receive chain with a system for motion detection in magnetic resonance imaging in accordance with another embodiment of the invention,
Fig. 3 shows a graph of the noise figure characteristic of a pre-amplifier,
Fig. 4 illustrates a Smith chart showing circles of constant noise figures in accordance with an embodiment of the invention,
Fig. 5 illustrates a flow chart illustrating a method for motion detection in magnetic resonace imaging in accordance with an embodiment of the invention,
Fig. 6 illustrates a flow chart illustrating a method for motion detection in magnetic resonace imaging in accordance with another embodiment of the invention.

### DETAILED DESCRIPTION OF EMBODIMENTS

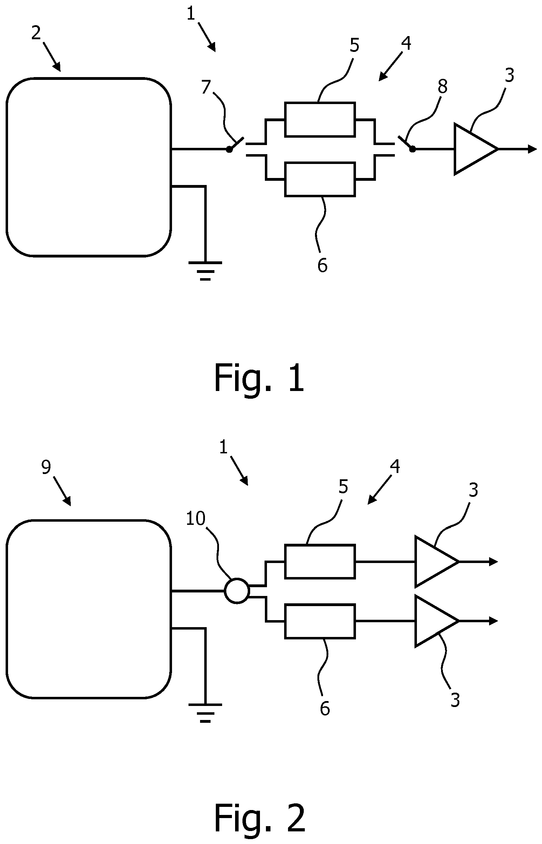

With reference to Fig. 1 a RF receive chain 1 of a magnetic resonance examination system with a system for motion detection in magnetic resonance imaging in accordance with an embodiment of the invention is shown. The RF receive chain 1 consists of a RF coil 2, a switchable impedance matching circuit 4 and a pre-amplifier 3. The RF coil 2 can be a RF receiver coil or a transmit/receive (Tx/Rx) coil. The combination of a transmit and receive RF coil in a single device can be useful for applications with X-nuclei MR spectroscopy or at ultrahigh-field MRI due to lack of body transmitter. The RF coil 2 is connected to the pre-amplifier 3 via the switchable impedance matching circuit 4. The output impedance of the RF coil 2 is transformed by the switchable impedance matching circuit 4 to the desired load impedance. The switchable impedance matching circuit 4 shown in Fig. 1 allows adjustment of the load impedance presented to the pre-amplifier 3 by the RF receiver coil 2 to different operating points. Therefore, the switchable impedance matching circuit 4 consists of a first impedance matching circuit 5 wherein the first impedance matching circuit 5 has an operating point that is optimized for an high Signal-to-Noise-Ratio. During data acquisition of the MR-signal the SNR should be maximal and thus the switchable impedance matching circuit 4 is switched to operate at minimal noise figure. The switchable impedance matching circuit 4 further comprises a second impedance matching circuit 6 wherein the second impedance matching circuit 6 has an operating point that is optimized for high derivative noise figure with respect to the input impedance of the pre-amplifier. For the acquisition of the noise signal for motion detection the operating point is switched to a region where the absolute value of the derivative of the noise figure in terms of input impedance is maximal or at least greatly increased.

The RF coil 2 is switched between the first impedance matching circuit 5 and the second impedance matching circuit 6 by a switch 7. When using a Tx/Rx coil the switch is a Tx/Rx switch. The switch 7 can e.g. be a Micro-Electromechanical Systems (MEMS). MEMS based RF-switches allow an increased switching speed, better power handling and reduced insertion loss. When controlling and switching multiple receiver coil arrays MEMs based RF-switches will reduce power consumption, cabling requirements, and increase overall SNR. MEMs switches also provide reduced fabrication costs and significant system cost impact. Other switches 7 that can be used to switch the RF coil 2 between the impedance matching circuits 5, 6 are e.g. PIN-Diodes or MOSFET switches. The aforementioned switches can also be used to switch 8 the first 5 or second impedance matching circuit 6 to the pre-amplifier 3.

The noise signal may be detected at any time during the MR pulse sequence where no RF is transmitted or imaging signal is acquired. The detected noise variations are post-processed to derive relative changes in the coil impedance, which in turn contain the motion information. For the data extraction, various analysis tools like principal component analysis, independent component analysis, regression methods, non-linear optimization, or neural networks may be used.

With reference to Fig. 2 a RF receive chain 1 with a system for motion detection in magnetic resonance imaging in accordance with another embodiment of the invention is shown. The RF coil 9 shown in Fig. 2 is a multi-frequency coil 9 with at least two different RF antennas. By using two different RF antennas, the RF coil 9 has also two different resonances. The RF receive chain 2 is optimized for the first resonance frequency. The second resonance frequency is e.g. double as high as the first resonance frequency. By using a resonance frequency double as high as the first resonance frequency the system is noisy at this frequency. This noise can be used for subject motion detection. By using two pre-amplifiers 3, the MR imaging signal and the noise signal can be measured simultaneously. In an embodiment of the invention the switching to a pre-amplifier 3 input impedance with a high derivative of noise figure is realized by switching the frequency of the MRI antenna. In another embodiment using different impedances of the MRI antenna is by switching the frequency of the coil.

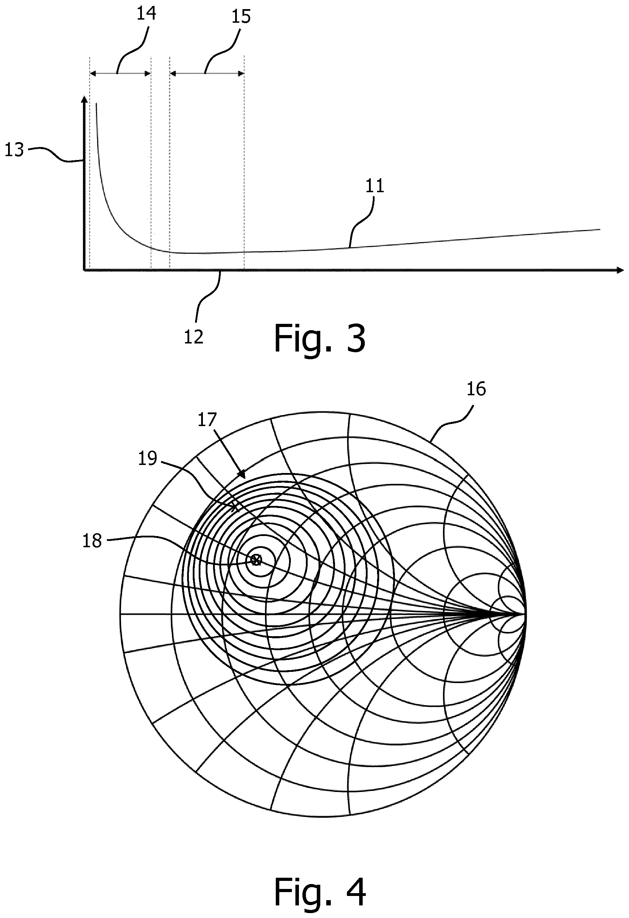

With reference to Fig. 3 a graph 11 of the noise figure characteristic of a pre-amplifier 3 used in magnetic resonance imaging is shown. In Fig. 3, the noise figure 13 is plotted against the input impedance 12. Depending on the presented load impedance at the pre-amplifier 3 input the operation is optimized for maximum Signal-to-Noise-Ration 15 or optimal noise sensitivity 14 and therefore for an optimal subject motion sensitivity. For a lower input impedance of the pre-amplifier, the noise figure is strongly increasing. This range of the noise figure 14 is used for an operating point that is optimized for high derivative noise figure. In the minimum of the graph 11, the noise figure is the lowest for a given input impedance. This region for the input impedance is used for an optimal Signal-to-Noise-Ratio 15.

With reference to Fig. 4 a smith chart 16 with circles of constant noise figures 17 is shown. In the smith chart 16, two matching points 18, 19 for an impedance matching are marked. The first matching point 18 in the center of the circles 17 is for a high Signal-to-Noise-Ratio. The noise figure is between 0.2 and 0.4. The second matching point 19 with a high derivative noise figure with respect to the input impedance of the pre-amplifier is the operating point for enhanced motion sensitivity. Every matching point 18, 19 corresponds in an embodiment of the invention to a separate pre-amplifier 3, which are switchable separated from each other.

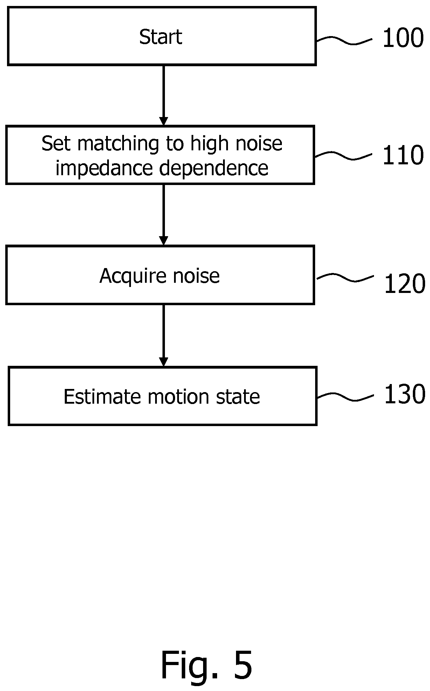

With reference to Fig. 5 a flow chart illustrating a method for motion detection in magnetic resonance imaging in accordance with an embodiment of the invention is shown. The method starts at step 100. In Step 110 the matching of the switchable impedance matching circuit 4 is set to a high noise impedance dependence. This is done by switching the RF coil 2, 9 to the second impedance matching circuit 6 wherein the circuit has an operating point that is optimized for high derivative noise figure with respect to the input impedance of the pre-amplifier. In step 120 noise is acquired by receiving noise signals by the RF coil 2. In step 130 the subject motion is estimated by extracting a motion signal from the noise signal. For the data extraction, various analysis tools like principal component analysis, independent component analysis, regression methods, non-linear optimization, or neural networks may be used.

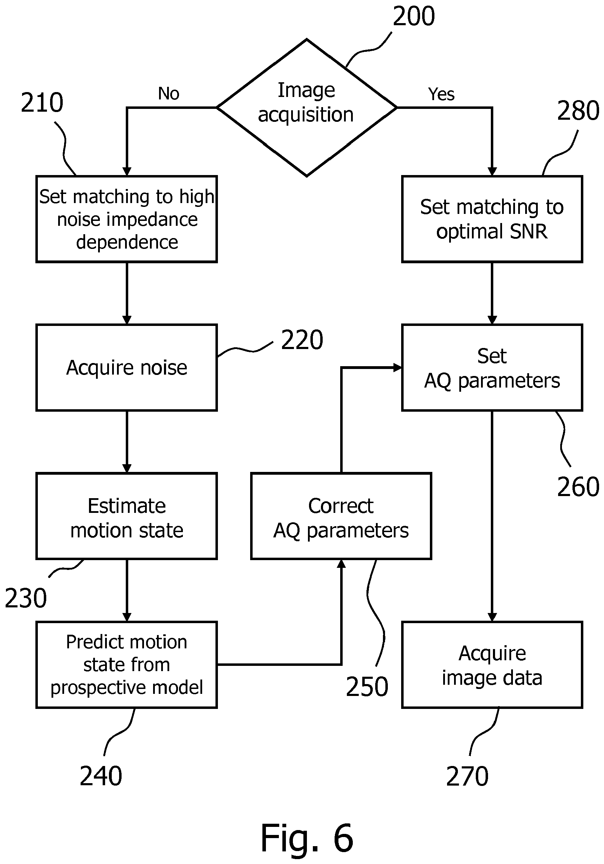

Fig. 6 shows a flow chart that illustrates additional method steps, which may be performed in the method of Fig. 5 in accordance with another embodiment of the invention. The method starts with step 200. In step 200 it is checked whether an image acquisition of a magnetic resonance imaging system takes place. If no image acquisition takes place the matching is set in step 210 to a high noise impedance dependency. Step 210 is equivalent to step 110 of Fig. 5. The matching to a high noise impedance dependency is done by switching the RF coil 2 to the second impedance matching circuit 6 wherein the circuit has an operating point that is optimized for high derivative noise figure with respect to the input impedance of the pre-amplifier. Step 220 is equivalent to step 120 of Fig. 5 wherein the noise is acquired by receiving noise signals by the RF coil 2. Step 230 is equivalent to step 130 of Fig 5 wherein the subject motion is estimated by extracting a motion signal from the noise signal. The subject motion state estimated in step 230 is used in step 240 to predict a motion state from a prospective model. The predicted subject motion is used in step 250 to correct the optimal Magnetic Resonance Imaging (MRI) acquisition parameters. The corrected acquisition parameters are set in step 260. In step 270 image data are then be acquired with reduced motion failures.

If in step 200 an image acquisition of a magnetic resonance imaging system takes place, the matching is set to an optimal Signal-to-Noise-Ratio in step 280 followed by setting the optimal Magnetic Resonance Imaging (MRI) acquisition parameters for imaging in an MRI system in step 260. After that, image data is acquired in step 270.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| RF receive chain | 1 |
| RF coil | 2 |
| pre-amplifier | 3 |
| switchable impedance matching circuit | 4 |
| first impedance matching circuit | 5 |
| second impedance matching circuit | 6 |
| first switch | 7 |
| second switch | 8 |
| multi frequency RF coil | 9 |
| frequency switch | 10 |
| noise figure vs. input impedance | 11 |
| input impedance | 12 |
| noise figure | 13 |
| optimal motion sensitivity | 14 |
| optimal Signal-to-Noise-Ratio | 15 |
| smith chart | 16 |
| circles of constant noise figure | 17 |
| operating point for optimal Signal-to-Noise-Ratio | 18 |
| operating point for optimal motion sensitivity | 19 |
| set matching to high noise impedance dependency | 110 |
| acquire noise | 120 |
| estimate motion state | 130 |
| image acquisition | 200 |
| set matching to high noise impedance dependence | 210 |
| acquire noise | 220 |
| estimate motion state | 230 |
| predict motion state from prospective model | 240 |
| correct AQ parameters | 250 |
| set AQ parameters | 260 |
| acquire image data | 270 |
| set matching to optimal Signal-to-Noise-Ratio | 280 |

## Claims

1. A system for detecting subject motion in magnetic resonance imaging the system comprising:
- at least one radio frequency (RF) receive chain (1) with at least one RF coil (2, 9), wherein the RF coil is configured for receiving RF signals, the RF coil (2, 9) being connected, via a switchable impedance matching circuit (4) to at least one pre-amplifier (3), wherein the switchable impedance matching circuit (4) comprises,
- a first impedance matching circuit (5), wherein the first impedance matching circuit (5) has an operating point that is optimized for a high Signal-to-Noise-Ratio, the switchable impedance matching circuit (4) further comprises at least a second impedance matching circuit (6), wherein the second impedance matching circuit (6) has an operating point that is optimized for high derivative noise figure with respect to an input impedance of the pre-amplifier.

2. The system according to claim 1, wherein the RF coil is an RF receiver coil or a transmit/receive (Tx/Rx) coil.

3. The system according to any preceding claim, wherein the system comprises a first switch (7) to switch the RF coil (2, 9) between the first impedance matching circuit (5) and the second impedance matching circuit (6).

4. The system according to claim 2, wherein the switch is a transmit/receive (Tx/Rx) switch.

5. The system according to any preceding claims, wherein the system comprises a second switch (8) to switch the first impedance matching circuit (5) or the second impedance matching circuit (6) to the at least one pre-amplifier (3).

6. The system according to any preceding claim, wherein the RF coil (2, 9) is a multi frequency RF coil (9).

7. The system according to claim 6, wherein the multi frequency RF coil (9) is connected to the pre-amplifier (3) via the switchable impedance matching circuit (4) wherein the switching between the first impedance matching circuit (5) and the second impedance matching circuit (6) is realized by switching the frequency of the multi frequency RF coil (9).

8. The system according to any preceding claim, wherein a pre-amplifier (3) is connected to the first impedance matching circuit (5) and a pre-amplifier (3) is connected to the second impedance matching circuit (6).

9. The system according to any preceding claim, wherein the switch (7, 8) is a PIN device or a MEM device.

10. A method for detecting subject motion in magnetic resonance imaging the method comprising the following steps:
- providing at least one RF receive chain (1) with at least one RF coil (2, 9), wherein the RF coil is configured for at least receiving RF signals,
- providing a switchable matching circuit (4), wherein the switchable impedance matching circuit (4) comprises, a first impedance matching circuit (5), wherein the first impedance matching circuit (5) has an operating point that is optimized for an high Signal-to-Noise-Ratio, the switchable impedance matching circuit (4) further comprises at least a second impedance matching circuit (6) wherein the second impedance matching circuit (6) has an operating point that is optimized for high derivative noise figure with respect to an input impedance of the pre-amplifier,
- switching the RF coil (2, 9) to the second impedance matching circuit (6),
- aquiring noise with the RF coil (2, 9),
- estimating subject motion by the measured noise.

11. The method according to claim 10, wherein the method further comprises the steps of:
- predicting a subject motion state from a prospective model,
- correcting magnetic resonance imaging acquisition parameters, based on the predicted subject motion state,
- setting the magnetic resonance imaging acquisition parameters,
- aquiring magnetic resonance image data.

12. The method according to claim 10 or 11, wherein the step of switching the RF coil (2, 9) to the second impedance matching circuit (6), includes the step of setting the second impedance matching circuit (6) to a region where the absolute value of the derivative of the noise figure in terms of the input impedance is maximal.

13. A magnetic resonance imaging system comprising a system for detecting subject motion according to claims 1 to 9.

14. A computer program product for motion detection in magnetic resonance imaging when executed by a computer, said computer program product carrying out the method according to claims 10 to 12.

15. A computer readable medium containing program instructions for execution on a computer system, which when executed by a computer, cause the computer to perform method steps for detecting subject motion.
